# EUROPEAN PATENT APPLICATION

(11) **EP 0 994 564 A1**
(43) Date of publication of application: **19.04.2000**
(21) Application number: 99307834.4
(22) Date of filing: 05.10.1999
(51) Int. Cl.: H03K 5/156, H03K 5/08, H03K 19/00

(54) **Inverter circuit with duty cycle control**

(30) Priority: 14.10.1998 US 172281
(71) Applicant: LUCENT TECHNOLOGIES INC., Murray Hill, New Jersey 07974-0636 (US)
(72) Inventor: Wang, Hongmo, Watchung, New Jersey 07060 (US)
(74) Representative: Buckley, Christopher Simon Thirsk

(57) **Abstract**

An inverter circuit (100) having a duty cycle control feature for adjusting the duty cycle of an output signal, (Vₒ), includes a pair of transistors (Q₁, Q₂) sharing a common input signal (Vᵢ) that is provided to the transistor gate terminals (G), and which produce an output signal having a duty cycle from the transistor drain terminals (D). A control circuit (120) is connected between the transistor drain terminals and at least one of the transistor backgate terminals (bg) for providing negative feedback to the backgate terminal, thereby adjusting the threshold voltage of the transistor whose backgate terminal receives the negative feedback.

## Description

### Field of the Invention

This invention relates to inverter circuits and more particularly to a CMOS inverter circuit having a feature for controlling the duty cycle of the circuit.

### Description of the Related Art

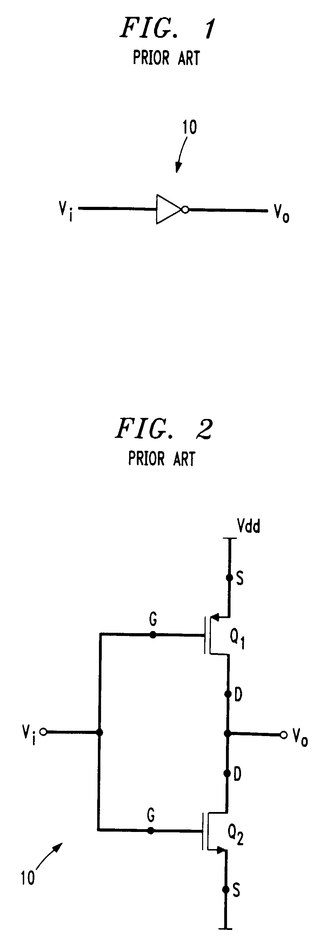

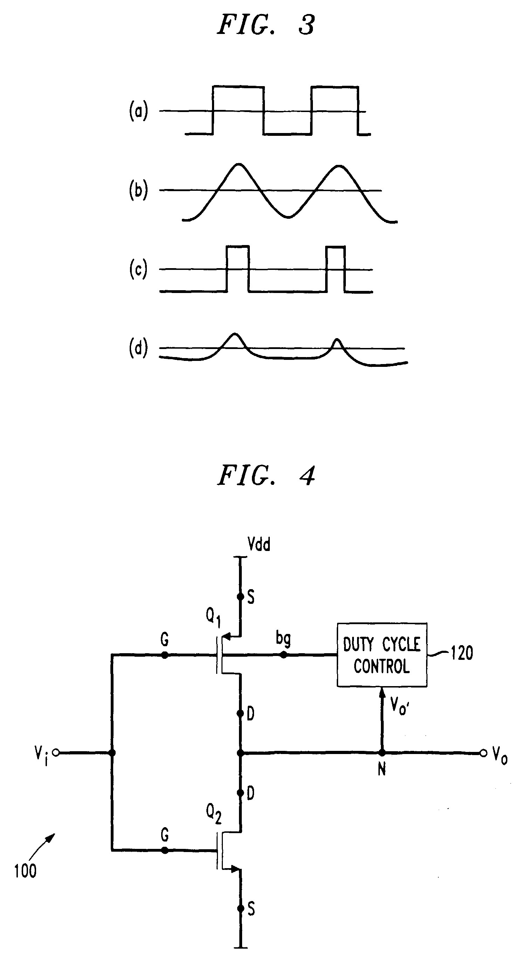

Inverter circuits and, in particular, CMOS inverter circuits are essential components of digital circuitry. An important consideration of an inverter circuit is its duty cycle. Precise duty cycle control can greatly affect the circuit performance. A prior art CMOS inverter 10, which is shown symbolically in FIG. 1 and schematically in FIG. 2, is formed of a pair of CMOS transistors Q₁ and Q₂, with Q₁ being a PMOS transistor and Q₂ an NMOS transistor. A common input signal Vᵢ is applied to the gate terminals of Q₁ and Q₂ and an output signal Vₒ is produced from the drain terminals. For an ideal CMOS inverter circuit, a low frequency input signal Vᵢ will yield an output signal Vₒ having an equal or balanced duty cycle as shown in FIG. 3(a); for a high frequency input signal, a balanced high frequency duty cycle is produced as shown in FIG. 3(b). However, due to variations in manufacturing processes used for producing CMOS transistors, losses in the output signal will result, as for example shown in the signal depicted in FIG. 3(c) for a low frequency input signal, with increased output signal losses for a high frequency input signal as shown in FIG. 3(d). Although various techniques exist for correcting or adjusting the duty cycle of a CMOS inverter, such techniques are difficult and expensive to implement.

### Summary Of The Invention

In accordance with the present invention, an inverter circuit having a duty cycle control feature is disclosed. The inverter circuit is formed of CMOS transistors and, in particular, a PMOS transistor and an NMOS transistor. Each transistor has a gate, a source, a drain and a backgate terminal. The transistors are configured so that a common input signal is applied to the transistor gate terminals and an output signal having a quiescent value and a dynamic value is produced from an output node formed between the drain terminals. A voltage control circuit is disposed between the output node and one of the transistor backgate terminals to provide negative feedback to the backgate terminal in the form of the quiescent value of the output signal. This adjusts the threshold voltage of the transistor receiving the feedback signal which, in turn, adjusts the duty cycle of the circuit.

In the preferred embodiment, the voltage control circuit is an operational amplifier which receives the output signal at its positive terminal and a reference voltage at its negative terminal.

Other objects and features of the present invention will become apparent from the following detailed description considered in conjunction with the accompanying drawings. It is to be understood, however, that the drawings are designed solely for purposes of illustration and not as a definition of the limits of the invention, for which reference should be made to the appended claims.

### Brief Description Of The Drawings

In the drawings, wherein like reference numerals denote similar elements throughout the several views:
FIG. 1 depicts a prior art inverter;
FIG. 2 is a schematic representation of the prior art inverter of FIG. 1;
FIGs. 3(a)-3(d) are graphical representations of output signal duty cycles for low and high frequency output signals; and
FIG. 4 is an inverter circuit having duty cycle control in accordance with the present invention.

### Detailed Description Of The Presently Preferred Embodiment

A schematic representation of an inverter circuit 100 in accordance with a preferred embodiment of the present invention is shown in FIG. 4. The circuit 100 contains a pair of transistors Q₁ and Q₂ which are preferably CMOS transistors, with Q₁ preferably a PMOS transistor and Q₂ preferably an NMOS transistor. It will be recognized by those having ordinary skill in the art that circuit 100 can be alternatively designed using transistors of opposite polarity (e.g., Q₁ being an NMOS device and Q₂ being a PMOS device) without departing from the scope of the present invention.

Each transistor has a gate terminal (g), a drain terminal (d), a source terminal (s) and a backgate terminal (bg). The gate terminals receive a common input signal Vᵢ. The source terminal of Q₁ is DC biased by V_{dd} and the source terminal of Q₂ is at ground. As is known, each transistor has a threshold voltage (V_{T}) and turns "on", i.e. conducts, when the voltage (V_{gs}) between the gate terminal and the source terminal exceeds V_{T}. Thus, as Q₁ and Q₂ are of opposite polarity (Q₁ is a PMOS device and Q₂ is an NMOS device), one transistor is "on" when the other is "off", thereby producing an output signal Vₒ having a duty cycle.

It is widely recognized that the threshold voltage of a MOSFET transistor and, in particular, a CMOS transistor, is a fixed value when the backgate terminal is tied to a fixed voltage but that the threshold voltage can be changed, i.e. raised to prevent turn-on or lowered to facilitate turn-on, by applying an appropriate voltage to the backgate terminal. It is also known that MOSFET transistors such as CMOS transistors have impedance values which are dependent on the turn-on voltages.

Bearing these principles in mind, the inverter 100 has an output node N which senses the quiescent voltage values from the drain terminals of Q₁ and Q₂, which are dependant on the impedance values of the transistors. If the impedance values of the transistors are equal, the inverter will have a 50% duty cycle and the quiescent value of the output signal will be 1/2 of the supply voltage (e.g. V₀ = V_{dd}/2). To control the duty cycle in accordance with the invention, the impedance values of the transistors are varied by adjusting the turn-on voltages, a procedure that is performed by applying a feedback signal to a backgate terminal of one or both of the transistors. To accomplish this, a voltage control circuit 102 is disposed between the output node N and one of the backgate terminals of the transistors (e.g. the backgate terminal of Q₁). The voltage control circuit 102 is switchably engageable with the output node N and provides negative feedback of the output voltage V₀ to the backgate terminal, thereby controlling the threshold voltage of Q₁ which, in turn, adjusts the duty cycle of V₀. It should be pointed out that the feedback voltage (shown as V₀') is the quiescent value of the output signal V₀ and not the dynamic state of the output signal.

With reference to FIG. 4, when control circuit 102 is switched or connected to the output node N, circuit 102 is realized by an operational amplifier receiving, at its positive terminal, the quiescent signal V₀', and at its negative terminal a reference voltage V_{ref}. The output of the operational amplifier is then provided to the backgate terminal of transistor Q₁. When the control circuit 102 is disconnected from the output node N, such as when the duty cycle is calibrated and the inverter no longer receives a symmetrical input signal Vᵢ, circuit 102 functions as a sample and hold device for maintaining the backgate terminal of Q₁ at an appropriate voltage for ensuring duty cycle calibration. Although this is a preferred embodiment of the control circuit 102, it will be appreciated by those having ordinary skill in the art that other feedback circuits can be readily employed without departing from the scope of the present invention.

Having now described the components of the inverter circuit 100, a description of its operation will follow. The inverter circuit can receive a symmetrical input signal, such as a clock signal, as well as a non-symmetrical input signal. For a symmetrical signal, if the output voltage V₀ is greater than the reference voltage V_{ref} which is applied to the control circuit 102, the output of 102 increases to a value above its prior state. This, in turn, causes the threshold voltage of transistor Q₁ to increase which increases the turn-on resistance of transistor Q₁, thus lowering the value of V₀ until V₀ approaches the value of V_{ref}. In the alternative, when the output voltage V₀ is less than the reference voltage, the output of control circuit 102 is reduced from its prior value, which causes the threshold voltage of transistor Q₁ to decrease, thereby causing the turn-on resistance of Q₁ to decrease and raising the output voltage value to approach the reference voltage value V_{ref}.

If the inverter circuit receives a non-symmetrical input signal, a test signal may first be applied to allow for duty cycle calibration. This is accomplished by providing the test signal, such as a clock or other symmetrical signal, as the input voltage Vᵢ and switching the control circuit 102 into connection with the output node N for duty cycle adjustment, as described above. Once adjustment of the duty cycle has been achieved, the control circuit 102 will be switched to a non-engaged position with node N and a control voltage will be applied to the backgate terminal of Q₁ to maintain duty cycle calibration, whereupon the desired non-symmetrical input signal can be provided.

While there have been shown and described and pointed out fundamental novel features of the present invention as applied to a preferred embodiment thereof, it will be understood that various omissions and substitutions and changes in the methods described and in the form and details of the devices illustrated, and in their operation, may be made by those skilled in the art without departing from the spirit of the present invention. For example, it is expressly intended that all combinations of those elements which perform substantially the same function in substantially the same way to achieve the same results are within the scope of the invention. It is also to be understood that the drawings are not necessarily drawn to scale but that they are merely conceptual in nature. It is the intention, therefore, to be limited only as indicated by the scope of the claims appended hereto.

## Claims

1. An inverter circuit for producing a varying output signal having a duty cycle and for providing adjustment of the duty cycle, comprising:
a first transistor having a first polarity, a first threshold voltage value, a first gate terminal, a first drain terminal, a first source terminal and a first backgate terminal;
a second transistor having a second polarity opposite from said first polarity and having a second threshold voltage value, a second gate terminal, a second drain terminal, a second source terminal and a second backgate terminal, said first and second transistors being configured so that the first and second gate terminals receive a common input signal and so that the first and second drain terminals output the output signal having the duty cycle; and
a duty cycle controller for controlling the duty cycle of the output signal, said duty cycle controller being connected between said drain terminals and one of said first and second backgate terminals for providing a feedback portion of the output signal to said one backgate terminal for manipulating the threshold voltage value of the transistor of said one of the backgate terminals.

2. The inverter circuit of claim 1, wherein said first transistor comprises a PMOS transistor and wherein said second transistor comprises an NMOS transistor.

3. The inverter circuit of claim 2, wherein the duty cycle controller is connected to said first backgate terminal of said first transistor.

4. The inverter circuit of claim 1, wherein said duty cycle controller comprises an operational amplifier.

5. The inverter circuit of claim 4, wherein said operational amplifier includes a positive terminal, a negative terminal and an output terminal, said positive terminal being connected to said first and second drain terminals, said negative terminal being connected to a reference voltage, and said output terminal being connected to the first backgate terminal of said first transistor.

6. The inverter circuit of claim 1, wherein said duty cycle controller is switchably engageable with said drain terminals.

7. The inverter of claim 6, wherein said duty cycle controller further comprises sample and hold means for providing a calibration signal to said one backgate terminal when said controller is disengaged from said drain terminals.
